Europäisches Patentamt

European Patent Office

Office européen des brevets

(11) Publication number: **0 273 123 B1**

# EUROPEAN PATENT SPECIFICATION

(45) Date of publication of patent specification: **15.04.92** (51) Int. Cl.5: **H03F 3/45**

(21) Application number: **87115292.2**

(22) Date of filing: **19.10.87**

(54) Improved operational amplifier utilizing JFET followers.

(30) Priority: **29.12.86 US 947127**

(43) Date of publication of application:
**06.07.88 Bulletin 88/27**

(45) Publication of the grant of the patent:
**15.04.92 Bulletin 92/16**

(84) Designated Contracting States:
**DE FR GB**

(56) References cited:
**US-A- 3 703 650**
**US-A- 4 241 314**

(73) Proprietor: **MOTOROLA INC.**
**Motorola Center 1303 Algonquin Rd.**
**Schaumburg Illinois 60196(US)**

(72) Inventor: **Susak, David M.**
**246 E. 9th Avenue**
**Mesa Arizona 85202(US)**
Inventor: **Vyne, Robert Leonard**
**5623 S. Holbrook Drive**
**Tempe Arizona 85283(US)**

(74) Representative: **Ibbotson, Harold et al**
**Motorola Ltd Patent and Licensing Oper-**
**ations - Europe Jays Close Viables Industrial**
**Estate**
**Basingstoke Hampshire RG22 4PD(GB)**

## Description

### Background of the Invention

This invention relates generally to operational amplifiers, and more particularly, to an operational amplifier utilizing JFET followers each of which is driven by a current source generating a current which is proportional to the saturation current $I_{DSS}$ of its respective JFET follower and which tracks its respective $I_{DSS}$ over temperature.

In an operation amplifier which utilizes JFET followers for driving a PNP differential stage, it is desirable that the JFETs be supplied each with a current equal to $I_{DSS}$ (the drain current when the gate and source terminals are shorted) and in this manner provide a gate-to-source voltage ($V_{gs}$) equal to zero and having a temperature coefficient equal to zero (i.e. $dV_{gs}/dT = 0$). Furthermore, with $V_{gs}$ on both sides of the amplifier (i.e. $V_{gs1}$ and $V_{gs2}$) equal to zero, the offset voltage Vos which equals $V_{gs1}$-$V_{gs2}$ would also equal zero and $dV_{os}/dT$ would equal zero. Unfortunately, in the past, the required currents equal to $I_{DSS}$ of the JFET followers could not be assured sufficiently to achieve consistently acceptable results.

The following patents are noted as disclosing subject matter related to the present invention: US-A-3,703,650 discloses an amplifier circuit with JFET followers conducting $I_{DSS}/2$ and having constant $V_{DS}$ for providing a zero temperature coefficient thereof, and US-A-4,241,314 features another amplifier circuit with JFET followers.

### Summary of the Invention

It is an object of the present invention to provide an improved operational amplifier circuit utilizing JFET followers.

According to a broad aspect of the invention there is provided an amplifier having first and second inputs and comprising first and second emitter coupled transistors ($Q_3$, $Q_4$) each having a base, collector and emitter, the emitters being coupled to a first source of supply voltage; current mirror means ($D_1$, $Q_5$) having an input and output respectively coupled to the collectors of the first and second transistors; a first JFET ($Q_1$) having a source coupled to the base of the first transistor, a drain coupled to a second source of supply voltage, and a gate coupled to the first input, and having a first $I_{DSS}$; and a second JFET ($Q_2$) having a source coupled to the base of the second transistor, a drain coupled to the second source of supply voltage, and a gate coupled to the second input, and having a second $I_{DSS}$, the amplifier circuit characterized by;

first means ($I_1$) coupled to the source of the first JFET for supplying a first current thereto substantially equal to the first $I_{DSS}$, said first means including,

(a) a third JFET ($Q_6$) having a source coupled to the first source of supply voltage, a drain coupled to the source of the first JFET for conducting said first current, and having a gate, and

(b) a first adjustable resistor ($R_T$) having a first terminal coupled to the first source of supply voltage and a second terminal coupled to said gate of said third JFET and to a source of a reference current ($I_{REF}$); and

second means ($I_2$) coupled to the source of the second JFET for supplying a second current thereto substantially equal to the second $I_{DSS}$, said second means including,

(a) a fourth JFET ($Q_6$) having a source coupled to the first source of supply voltage, a drain coupled to the source of the second JFET for conducting said second current, and having a gate, and

(b) a second adjustable resistor ($R_T$) having a first terminal coupled to the first source of supply voltage and a second terminal coupled to said gate of said fourth JFET and to said source of a reference current.

The above and other objects, features and advantages of the present invention will be more clearly understood from the following detailed description taken in conjunction with the accompanying drawings, in which:

### Brief Description of the Drawings

Fig. 1 is a schematic diagram of the inventive operational amplifier circuit; and

Fig. 2 is a schematic diagram of a current source for generating currents $I_1$ and $I_2$ in Fig. 1.

### Description of the Preferred Embodiment

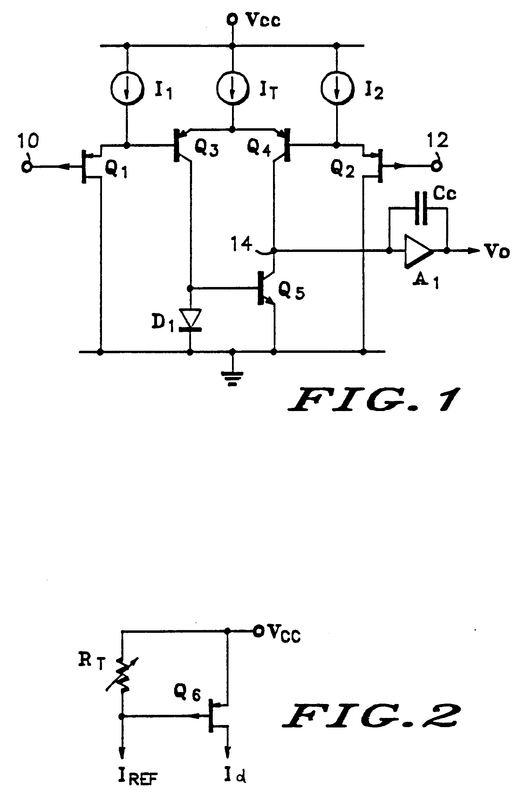

The operational amplifier shown in Fig. 1 includes a pair of emitter coupled PNP transistors Q3 and Q4 each of which have their collectors coupled to a current mirror circuit comprised of diode means $D_1$ and NPN transistor Q5. That is, the collector of PNP transistor Q3 is coupled to the anode of diode D1 and to the base of transistor Q5. The collector of transistor Q4 is coupled to the collector of transistor Q5. Both the cathode of diode D1 and emitter of transistor Q5 are coupled to a source of supply voltage (e.g. ground). The tail current required by this circuitry is provided by a current source $I_t$ coupled between the emitters of transistors Q3 and Q4 and another source of supply voltage ($V_{CC}$). The base electrodes of transistors Q3 and Q4 are coupled respectively to the source electrodes of junction field-effect-transistors (JFETs) Q1 and Q2 respectively each of which have a drain coupled to ground. Q1 has a gate terminal coupled to a first input terminal 10, and Q2 has a gate coupled to a second input terminal 12. The remainder of the operational amplifier represented by amplifier A1 having an input coupled to the collector junction of transistors Q4 and Q5, the output of which ($V_0$) represents the amplifier output, and a compensation capacitor $C_c$ coupled in parallel with amplifier $A_1$). Finally, current sources $I_1$ and $I_2$ are provided for driving junction field-effect-transistors Q1 and Q2 respectively, and it is the nature of these current sources and their relationship to the circuit as a whole which renders the circuit shown in FIG. 1 inventive.

The gate to source voltage ($V_{gs}$) of a JFET may be represented as

$$V_{gs} = V_p(1 - \sqrt{I_D/I_{DSS}}) \qquad (1)$$

where $V_p$ is a pinch-off voltage of the JFET, $I_D$ is the drain current and $I_{DSS}$ represents the JFET's drain current when its gate and source are shorted. The amplifier's offset voltage ($V_{os}$) may then be represented as the difference between the gate to source voltage of Q2 and Q1 or

$$V_{os} = V_{gsQ2} - V_{gsQ1} \qquad (2)$$

By substituting, there is obtained

$$V_{os} = V_{pQ2} (1- \sqrt{I_2/I_{DSSQ2}}) - V_{pQ1}(1-\sqrt{I_1/I_{DSSQ1}}) \qquad (3)$$

If $dI_2/dT = dI_{DSSQ2}/dT$ and $dI_1/dT = dI_{DSSQ1}/dT$ the rate of change of the offset voltage with respect to temperature may be represented as

$$dV_{os}/dT = (dV_{pQ2}/dT) (1- \sqrt{I_2/I_{DSSQ2}} - (dV_{pQ1}/dT) (1-\sqrt{I_1/I_{DSSQ1}}) \qquad (4)$$

It can be seen that if $I_2$ is substantially equal to $I_{DSSQ2}$ and $I_1$ is substantially equal to $I_{DSSQ1}$, then both the offset voltage $V_{os}$ and the rate of change of $V_{os}$ with temperature ($dV_{os}/dT$) equals zero. That is, by trimming the offset voltage to zero, $dV_{os}/dT$ is also automatically trimmed to zero.

Current sources I1 and I2 are be generated by the circuit shown in Fig. 2.

Referring to Fig. 2, each inventive current source comprises a JFET Q6 having a source coupled to a source of supply voltage $V_{CC}$ and having a drain at which the required current $I_1$, $I_2$ is made available. The gate of $Q_6$ is coupled via a trimmable resistor $R_T$ to the source of supply $V_{CC}$. The gate is also coupled to the source of a reference current $I_{REF}$.

The reference current $I_{REF}$ is equal to $V_p/R$

where $V_p$ is the pinch-off voltage of a JFET and R is some resistance.

Referring again to FIG. 2, $I_1$ or $I_2$ (hereinafter "$I_d$") may be expressed as

$$I_d = I_{DSS} (1 - V_{gs}/V_p)^2 \qquad (5)$$

where $V_{gs}$ is the gate to source voltage of $Q_6$ and $V_p$ is the pinch-off voltage of $Q_6$. Since the source of $Q_6$ is biased above its gate, $V_{gs}$ may be expressed as

$$V_{gs} = -I_{REF} R_T \qquad (6)$$

Substituting Equation (6) into equation (5) yields

$$I_d = I_{DSS} (1 + I_{REF} R_T/V_p)^2 \qquad (7)$$

As previously described, $I_{REF}$ equals $V_p/R$. Therefore,

$$I_d = I_{DSS} (1 + V_pR_T/V_pR)^2 \qquad (8)$$

As long as JFET $Q_6$ and the current source generating $I_{REF}$ are in close proximity, their pinch-off voltages will be substantially equal and Equation (8) becomes

$$I_d = I_{DSS} (1 + R_T/R)^2 \qquad (9)$$

Thus, it can be seen that $I_d$ appearing at the drain of JFET $Q_6$ is proportional $I_{DSS}$ and may be trimmed simply by altering the ratio of $R_T/R$. This is accomplished by adjusting trimmable resistor $R_T$. Through this mechanism, $I_d$ may be adjusted so as to be equal to $I_{DSS}$.

If we next assume that resistors R and $R_T$ are of the same type, then

$$dR/dT = dR_T/dT \qquad (10)$$

and the temperature coefficient of R is substantially identical to that of $R_T$. That is

$$dI_d/dT = (dI_{DSS}/dT)(1 + R_T/R)^2 \qquad (11)$$

This being the case, the temperature coefficient of $I_D$ is proportional to that $I_{DSS}$. Thus, the circuit shown in FIG. 2 when driven by a reference current equal to $V_P/R$ produces a current $I_d$ which is proportional to $I_{DSS}$ and trimmable and one which has a temperature coefficient which is proportional to that of $I_{DSS}$.

Aside from the above, the operational amplifier shown in FIG. 1 operates in the well known manner. That is, when the voltage at terminal 10 is greater than that at terminal 12, JFET Q1 turns on causing the voltage at the base of transistor Q3 to fall thus turning it on. The current flowing in the collector of Q3 will thus be greater than that flowing in the collector of Q4. Since the current mirror action of diode D1 and transistor Q5 will attempt to mirror the current flowing in the collector of Q3 in the collector of Q5, the voltage at node 14 which is applied to the amplifier's output stage will fall. In contrast, should the potential at input terminal 10 be less than that at terminal 12, JFET Q2 will turn on causing transistor Q4 to conduct harder than transistor Q3. In this case, the current being mirrored to the collector of transistor Q5 is less than that flowing in the collector of transistor Q4 and the voltage at node 14 will rise.

## Claims

1. An amplifier having first (10) and second (12) inputs and comprising first and second emitter coupled transistors ($Q_3$, $Q_4$) each having a base, collector and emitter, the emitters being coupled to a first source of supply voltage; current mirror means ($D_1$, $Q_5$) having an input and output respectively coupled to the collectors of the first and second transistors; a first JFET ($Q_1$) having a source coupled to the base of the first transistor, a drain coupled to a second source of supply voltage, and a gate coupled to the first input, and having a first $I_{DSS}$; and a second JFET ($Q_2$) having a source coupled to the base of the second transistor, a drain coupled to the second source of supply voltage, and a gate coupled to the second input, and having a second $I_{DSS}$, the amplifier circuit characterized by;

   first means ($I_1$) coupled to the source of the first JFET for supplying a first current thereto substantially equal to the first $I_{DSS}$, said first means including,

   (a) a third JFET ($Q_6$) having a source coupled to the first source of supply voltage, a drain coupled to the source of the first JFET for conducting said first current, and having a gate, and

   (b) a first adjustable resistor ($R_T$) having a first terminal coupled to the first source of supply voltage and a second terminal coupled to said gate of said third JFET and to a source of a reference current ($I_{REF}$); and

   second means ($I_2$) coupled to the source of the second JFET for supplying a second current thereto substantially equal to the second $I_{DSS}$, said second means including,

   (a) a fourth JFET ($Q_6$) having a source coupled to the first source of supply voltage, a drain coupled to the source of the second JFET for conducting said second current, and having a gate, and

   (b) a second adjustable resistor ($R_T$) having a first terminal coupled to the first source of supply voltage and a second terminal coupled to said gate of said fourth JFET and to said source of a reference current.

2. An amplifier according to claim 1 wherein each of the first and second transistors are PNP transistors.

3. An amplifier according to claim 2 wherein said source of a reference current is proportional to the pinch-off voltage of said third and fourth JFETs.

## Revendications

1. Amplificateur possédant une première entrée (10) et une deuxième entrée (12) et comprenant des premier et deuxième transistors à couplage par l'émetteur (Q3, Q4) qui possèdent chacun une base, un collecteur et un émetteur, les émetteurs étant couplés à une première source de tension d'alimentation ; un moyen miroir de courant (D1, Q5) possédant une entrée et une sortie qui sont respectivement couplées aux collecteurs des premier et deuxième transistors ; un premier transistor à effet de champ à jonction, ou JFET, (Q1) dont la source est couplée à la base du premier transistor, le drain est couplé à une deuxième source de tension d'alimentation et la grille est couplée à la première entrée, et qui possède un premier $I_{DSS}$, c'est-à-dire courant de drain avec grille et source en court-circuit ; et un deuxième JFET (Q2) dont la source est couplée à la base du deuxième transistor, le drain est couplé à la deuxième source de tension d'alimentation et la grille est couplée à la deuxième entrée, et qui possède un deuxième $I_{DSS}$, le circuit amplificateur étant caractérisé par :

   un premier moyen ($I_1$) couplé à la source du premier JFET et servant à fournir à celui-ci un premier courant qui est sensiblement égal au premier $I_{DSS}$, ledit premier moyen comportant :

   (a) un troisième JFET (Q6) dont la source est couplée à la première source de tension d'alimentation, dont le drain est couplé à la source du premier JFET afin de conduire ledit premier courant, et qui possède une grille, et

   (b) une première résistance ajustable ($R_T$) dont une première borne est couplée à la première source de tension d'alimentation et dont la deuxième borne est couplée à ladite grille dudit troisième JFET et à une source de courant de référence ($I_{REF}$) ; et

un deuxième moyen ($I_2$) couplé à la source du deuxième JFET et servant à fournir à celui-ci un deuxième courant qui est sensiblement égal au deuxième $I_{DSS}$, ledit deuxième moyen comportant :

(a) un quatrième JFET ($Q6$) dont la source est couplée à la première source de tension d'alimentation, dont le drain est couplé à la source du deuxième JFET afin de conduire ledit deuxième courant, et qui possède une grille, et

(b) une deuxième résistance ajustable ($R_T$) dont une première borne est couplée à la première source de tension d'alimentation et dont la deuxième borne est couplée à ladite grille dudit quatrième JFET et à ladite source de courant de référence.

**2.** Amplificateur selon la revendication 1, où lesdits premier et deuxième transistors sont chacun un transistor PNP.

**3.** Amplificateur selon la revendication 2, où le courant de ladite source de courant de référence est proportionnel à la tension de pincement desdits troisième et quatrième JFET.

**Patentansprüche**

**1.** Verstärker mit zwei Eingangsklemmen (10, 12), mit zwei über ihre Emitter verbundenen Transistoren ($Q_3$, $Q_4$), die jeweils eine Basis, einen Kollektor und einen Emitter aufweisen, und deren Emitter an einer ersten Ladespannungsquelle angeschlossen sind, mit einem Stromreflektor ($D_1$, $Q_5$), dessen Eingang bzw. Ausgang mit dem Kollektor der beiden Transistoren verbunden ist, mit einem ersten Übergangs-Feldeffekt-Transistor ($Q_1$), der mit seiner Quellenelektrode an der Basis des einen Transistors, mit seiner Zugelektrode an einer zweiten Ladespannungsquelle und mit seiner Torelektrode an der einen Eingangsklemme (10) angeschlossen ist, und dem ein Zugelektrodenstrom $I_{DSS}$ (bei kurzgeschlossener Tor- und Quellenelektrode) zugeleitet wird, und mit einem zweiten Übergangs-Feldeffekt-Transistor ($Q_2$), der mit seiner Quellenelektrode an der Basis des anderen Transistors, mit seiner Zugelektrode an der zweiten Ladespannungsquelle und mit seiner Torelektrode an der anderen Eingangsklemme angeschlossen ist, und dem ein weiterer Zugelektrodenstrom $I_{DSS}$ (bei kurzgeschlossener Tor- und Quellenelektrode) zugeleitet wird, gekennzeichnet

durch eine erste Einrichtung ($I_1$), die an der Quellenelektrode des ersten Übergangs-Feldeffekt-Transistors angeschlossen ist, um einen ersten Strom zuzuleiten, der im wesentlichen dem ersten Zugelektrodenstrom ($I_{DSS}$) entspricht, und die die folgenden Bestandteile aufweist:

(a) einen dritten Übergangs-Feldeffekt-Transistor ($Q_6$), der mit seiner Quellenelektrode an der ersten Ladespannungsquelle und mit seiner Zugelektrode zur Leitung des ersten Stromes an der Quellenelektrode des ersten Übergangs-Feldeffekt-Transistors angeschlossen ist, und der eine Torelektrode aufweist, und

(b) einen ersten einstellbaren Widerstand ($R_T$), der mit seiner einen Klemme an der ersten Ladespannungsquelle und mit seiner anderen Klemme an der Torelektrode des dritten Übergangs-Feldeffekt-Transistors und an einer Quelle eines Bezugsstromes ($I_{REF}$) angeschlossen ist,

und durch eine zweite Einrichtung ($I_2$), die an der Quellenelektrode des zweiten Übergangs-Feldeffekt-Transistors angeschlossen ist, um einen zweiten Strom zuzuleiten, der im wesentlichen dem zweiten Zugelektrodenstrom ($I_{DSS}$) entspricht, und die die folgenden Bestandteile aufweist:

a) einen vierten Übergangs-Feldeffekt-Transistor ($Q_6$), der mit seiner Quellenelektrode an der ersten Ladespannungsquelle und mit seiner Zugelektrode zur Leitung des zweiten Stromes an der Quellenelektrode des zweiten Übergangs-Feldeffekt-Transistors angeschlossen ist, und der eine Torelektrode aufweist, und

b) einen zweiten einstellbaren Widerstand ($R_T$), der mit seiner einen Klemme an der ersten Ladespannungsquelle und mit seiner anderen Klemme an der Torelektrode des vierten Übergangs-Feldeffekt-Transistors und an der Quelle eines Bezugsstromes angeschlossen ist.

**2.** Verstärker gemäß Anspruch 1, bei dem jeder der beiden Transistoren ein pnp-Transistor ist.

**3.** Verstärker gemäß Anspruch 2, bei dem die Quelle des Bezugsstromes der Klemmspannung des dritten und vierten Übergangs-Feldeffekt-Transistors proproportional ist.

FIG. 1

FIG.2